(19) **Europäisches Patentamt European Patent Office Office européen des brevets**

(11) **EP 3 776 632 B1**

(12) **FASCICULE DE BREVET EUROPEEN**

(45) Date de publication et mention de la délivrance du brevet:
**21.08.2024 Bulletin 2024/34**

(21) Numéro de dépôt: **19719549.8**

(22) Date de dépôt: **26.03.2019**

(51) Classification Internationale des Brevets (IPC):
**H10N 30/073** (2023.01)   **H03H 9/02** (2006.01)
**H01L 21/20** (2006.01)

(52) Classification Coopérative des Brevets (CPC):
**H01L 21/2007; H03H 9/02574; H10N 30/073**

(86) Numéro de dépôt international:
**PCT/FR2019/050685**

(87) Numéro de publication internationale:
**WO 2019/186053 (03.10.2019 Gazette 2019/40)**

(54) **PROCEDE DE FABRICATION D'UN SUBSTRAT POUR DISPOSITIF RADIOFREQUENCE**

**VERFAHREN ZUR HERSTELLUNG EINES SUBSTRATS FÜR EINEN RADIOFREQUENZFILTER**

**METHOD FOR MANUFACTURING A SUBSTRATE FOR A RADIOFREQUENCY DEVICE**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.03.2018 FR 1852574**

(43) Date de publication de la demande:
**17.02.2021 Bulletin 2021/07**

(73) Titulaire: **SOITEC**
**38190 Bernin (FR)**

(72) Inventeurs:
• **BELHACHEMI, Djamel**
**38400 SAINT MARTIN D'HERES (FR)**
• **BARGE, Thierry**
**38160 CHEVRIERES (FR)**

(74) Mandataire: **Regimbeau**
**20, rue de Chazelles**
**75847 Paris Cedex 17 (FR)**

(56) Documents cités:
FR-A1- 3 045 678      FR-A1- 3 053 532
US-A1- 2006 076 584   US-A1- 2012 086 312

**EP 3 776 632 B1**

## Description

## DOMAINE DE L'INVENTION

La présente invention concerne un procédé de fabrication d'un substrat pour dispositif radiofréquence.

## ARRIERE PLAN DE L'INVENTION

Il est connu de fabriquer un dispositif radiofréquence (RF), tel qu'un résonateur ou filtre, sur un substrat comprenant successivement, de sa base vers sa surface, un substrat support, généralement en un matériau semi-conducteur tel que du silicium, une couche électriquement isolante et une couche piézoélectrique.

Les filtres à ondes acoustiques de surface (SAW, acronyme du terme anglo-saxon « Surface Acoustic Wave ») comprennent typiquement une couche piézoélectrique épaisse (c'est-à-dire d'épaisseur généralement de plusieurs dizaines de $\mu$m) et deux électrodes sous la forme de deux peignes métalliques interdigités déposés sur la surface de ladite couche piézoélectrique. Un signal électrique, typiquement une variation de tension électrique, appliqué à une électrode est converti en onde élastique qui se propage à la surface de la couche piézoélectrique. La propagation de cette onde élastique est favorisée si la fréquence de l'onde correspond à la bande de fréquence du filtre. Cette onde est à nouveau convertie en signal électrique en parvenant à l'autre électrode.

Cependant, il existe des modes parasites de propagation de l'onde qui s'étendent dans l'épaisseur de la couche piézoélectrique et sont susceptibles de se refléter à l'interface avec le substrat support sous-jacent. Ce phénomène est appelé « rattle » en anglais.

Pour éviter ces modes parasites, il est connu de faire en sorte que la surface de la couche piézoélectrique située à l'interface avec la couche électriquement isolante soit suffisamment rugueuse pour permettre une réflexion des ondes parasites dans toutes les directions (effet dispersion) et éviter leur transmission dans le substrat.

Compte tenu de la longueur d'onde considérée, la rugosité de la surface de la couche piézoélectrique est très élevée, de l'ordre de quelques $\mu$m.

La fabrication du substrat implique de coller la surface rugueuse de la couche piézoélectrique, éventuellement recouverte de la couche électriquement isolante, sur le substrat support.

Cependant, pour assurer une bonne adhésion entre la couche piézoélectrique et le substrat support en dépit d'une telle rugosité, le procédé actuel nécessite un grand nombre d'étapes successives, qui le rendent long et coûteux.

Ainsi, un procédé pourrait comprendre les étapes suivantes :

- dépôt d'une couche d'oxyde de silicium ($SiO_2$), par dépôt chimique en phase vapeur assisté par plasma (PECVD) sur la surface rugueuse de la couche piézoélectrique, sur une épaisseur de 2 $\mu$m environ,
- dépôt d'une première couche de $SiO_2$ sur la surface de la couche piézoélectrique opposée à la surface rugueuse, sur une épaisseur de 0,5 $\mu$m environ,
- mise en oeuvre d'un premier polissage mécano-chimique (CMP, acronyme du terme anglo-saxon « Chemical Mechanical Polishing ») de la couche de $SiO_2$ déposée sur la surface rugueuse ; cependant, la rugosité obtenue à la suite de ce polissage reste trop élevé pour un collage de bonne qualité,
- dépôt d'une deuxième couche de $SiO_2$ sur la surface de la couche piézoélectrique opposée à la surface rugueuse, sur une épaisseur de 0,5 $\mu$m environ,
- mise en oeuvre d'un deuxième polissage mécano-chimique (CMP, acronyme du terme anglo-saxon « Chemical Mechanical Polishing ») de la couche de $SiO_2$ déposée sur la surface rugueuse, jusqu'à une rugosité suffisante pour permettre un collage de bonne qualité de la couche piézoélectrique recouverte de la couche de $SiO_2$, sur le substrat support, ledit substrat support étant lui-même recouvert d'une couche de $SiO_2$ nécessitant un polissage mécano-chimique (CMP, acronyme du terme anglo-saxon « Chemical Mechanical Polishing »).

Outre le coût induit par la mise en oeuvre des étapes susmentionnées côté substrat support ainsi que côté couche piézoélectrique, ce procédé présente l'inconvénient de générer une courbure importante du substrat (« bow » selon la terminologie-anglo-saxonne), du fait que le dépôt des couches de $SiO_2$ sur le substrat piézoélectrique est réalisé à haute température. Cette courbure perturbe les opérations réalisées ensuite sur le substrat pour la fabrication du filtre, qui sont adaptées à des substrats plans.

Les documents FR 3053532, FR 3045678, US 2012/086312 et US 2006/0076584 divulguent des procédés de fabrication de substrats comprenant une couche piézoélectrique pour applications radiofréquences.

## BREVE DESCRIPTION DE L'INVENTION

Un but de l'invention est de remédier aux inconvénients précités et notamment de concevoir un procédé de fabrication d'un substrat pour dispositif radiofréquence présentant un coût réduit et/ou une courbure diminuée par rapport au procédé de l'état de la technique.

A cet effet, l'invention propose un procédé de fabrication d'un substrat pour dispositif radiofréquence par assemblage d'une couche piézoélectrique sur un substrat support par l'intermédiaire d'une couche électriquement isolante, la couche piézoélectrique présentant une surface rugueuse présentant une rugosité comprise entre 0,3 et 5 $\mu$m RMS à son interface avec la couche électriquement isolante, ladite rugosité étant choisie du même ordre de grandeur que la longueur d'onde d'une onde radiofréquence destinée à se propager dans la couche piézoélectrique, de sorte à réfléchir une onde parasite sur ladite surface rugueuse, ledit procédé étant principalement caractérisé en ce qu'il comprend les étapes suivantes :

- la fourniture d'un substrat piézoélectrique présentant ladite surface rugueuse
- le dépôt d'une couche diélectrique sur la surface rugueuse du substrat piézoélectrique, ladite couche diélectrique comprenant une couche d'oxyde de silicium, une couche de nitrure de silicium, une couche comprenant une combinaison de nitrure et d'oxyde de silicium, et/ou une superposition d'au moins une couche d'oxyde et d'une couche de nitrure de silicium déposée sur le substrat piézoélectrique par dépôt chimique en phase vapeur assisté par plasma, ou une couche de verre déposée par centrifugation sur le substrat piézoélectrique,
- la fourniture d'un substrat support,
- le dépôt d'une couche adhésive photo-polymérisable sur le substrat support,
- le collage du substrat piézoélectrique sur le substrat support par l'intermédiaire de la couche diélectrique et de la couche adhésive, pour former un substrat assemblé,
- l'irradiation du substrat assemblé par un flux lumineux pour polymériser la couche adhésive, ladite couche adhésive et la couche diélectrique formant ensemble la couche électriquement isolante.

Par « surface rugueuse » on entend dans le présent texte une surface dont la rugosité est du même ordre de grandeur que la longueur d'onde des ondes RF destinées à se propager dans la couche piézoélectrique du filtre, de manière à permettre la réflexion des ondes parasites sur ladite surface. Dans le contexte de la présente invention, la rugosité d'une telle surface est comprise entre 0,3 et 5 $\mu$m RMS, de préférence comprise entre 1,5 et 2,2 $\mu$m RMS.

Un dispositif radiofréquence peut comporter un ou plusieurs résonateurs ou filtres. Pour une fréquence d'utilisation f donnée, l'homme du métier est en mesure de choisir les caractéristiques de la couche piézoélectrique notamment son matériau constitutif. Le choix du matériau et de sa coupe a une influence, pour une longueur d'onde $\lambda$ de l'onde RF considérée, sur la vitesse de propagation $\upsilon$ de l'onde, étant donné que ladite vitesse $\upsilon$ est liée à la fréquence f et à la longueur d'onde $\lambda$ par la relation (1) suivante :

$$f = \frac{\upsilon}{\lambda} \quad (1)$$

De plus, la fréquence f est liée à la géométrie p des électrodes du dispositif (qui se présentent généralement sous la forme de peignes métalliques interdigités déposés sur la surface de la couche piézoélectrique, p étant alors la distance périodique entre les peignes) via la relation (2) suivante réintroduite dans la relation (1) :

$$\lambda = 2 * p \quad (2)$$

Dès lors, en fonction de la fréquence de travail considérée, l'homme du métier peut ajuster l'intensité du couplage électromécanique du dispositif via la géométrie p des peignes interdigités, ainsi que la vitesse de propagation $\upsilon$ de l'onde via les caractéristiques du matériau de la couche piézoélectrique.

La mise en oeuvre du collage combinant la couche adhésive et la couche diélectrique permet de s'affranchir des étapes nécessaires à la formation d'une couche de $SiO_2$ suffisamment lisse sur la surface rugueuse, et d'éviter la mise en oeuvre de dépôts à haute température susceptibles d'engendrer une courbure importante du substrat. Par ailleurs, la couche diélectrique au contact de la couche piézoélectrique permet de conférer au substrat de bonnes performances acoustiques.

Selon d'autres aspects, le procédé proposé présente les différentes caractéristiques suivantes prises seules ou selon leurs combinaisons techniquement possibles :

- la couche diélectrique comprend une couche d'oxyde de silicium, une couche de nitrure de silicium, une couche comprenant une combinaison de nitrure et d'oxyde de silicium, et/ou une superposition d'au moins une couche d'oxyde et d'une couche de nitrure de silicium déposée sur le substrat piézoélectrique par dépôt chimique en phase vapeur assisté par plasma ;
- la couche diélectrique est une couche de verre déposée par centrifugation sur le substrat piézoélectrique ;
- l'épaisseur de la couche adhésive photo-polymérisable est comprise entre 2 $\mu$m et 8 $\mu$m ;
- le dépôt de la couche adhésive photo-polymérisable est mis en oeuvre par enduction centrifuge ;
- l'étape de collage est mise en oeuvre à une température comprise entre 20 et 50°C, de préférence entre 20°C et 30°C ;
- le flux lumineux est appliqué au travers du substrat piézoélectrique ;
- l'irradiation est mise en oeuvre de manière impulsionnelle ;
- le flux lumineux présente une longueur d'onde comprise entre 320 nm et 365 nm ;
- le substrat support est en un matériau possédant un coefficient de dilatation thermique inférieur à celui du matériau constitutif du substrat piézoélectrique ;
- le substrat support est en silicium, en saphir, en nitrure d'aluminium (AIN) polycristallin, ou en arséniure de gallium (GaAs) ;

- le procédé comprend en outre, après la polymérisation de la couche adhésive, une étape d'amincissement du substrat piézoélectrique de sorte à transférer sur le substrat support une couche piézoélectrique d'une épaisseur déterminée ;
- l'étape d'amincissement comprend une gravure et/ou un polissage mécano-chimique ;
- le procédé comprend, après l'étape d'amincissement, la mise en oeuvre d'un recuit de lissage de la couche piézoélectrique ;
- chaque étape postérieure au collage est mise en oeuvre à une température inférieure ou égale à 300°C ;

Un autre objet de l'invention concerne un procédé de fabrication d'un filtre radiofréquence, comprenant :

- la fabrication d'un substrat par le procédé de fabrication précédent,
- la formation d'une paire d'électrodes interdigitées sur la surface de la couche piézoélectrique dudit substrat.

L'invention se rapporte également à un substrat pour dispositif radiofréquence susceptible d'être obtenu par le procédé décrit plus haut, comprenant successivement un substrat support, une couche électriquement isolante et une couche piézoélectrique présentant, à son interface avec la couche électriquement isolante, une surface rugueuse présentant une rugosité comprise entre 0,3 et 5 µm RMS, la couche électriquement isolante comprenant successivement, du substrat support vers la couche piézoélectrique, une couche adhésive polymérisée et une couche diélectrique.

Un autre objet de l'invention est un filtre radiofréquence, comprenant un substrat tel que décrit précédemment et une paire d'électrodes interdigitées s'étendant sur la surface de la couche piézoélectrique.

**BREVE DESCRIPTION DES DESSINS**

D'autres caractéristiques et avantages de l'invention ressortiront de la description détaillée qui va suivre, en référence aux dessins annexés sur lesquels :

- la figure 1 illustre schématiquement l'étape de dépôt de la couche adhésive photo-polymérisable sur le substrat support ;
- la figure 2 illustre schématiquement l'étape de dépôt de la couche diélectrique sur le substrat piézoélectrique ;
- la figure 3 illustre schématiquement un substrat assemblé obtenu par collage du substrat support sur le substrat piézoélectrique, avec la couche adhésive et la couche diélectrique situées à l'interface de collage ;
- la figure 4 illustre schématiquement l'étape de polymérisation de la couche adhésive après collage du substrat piézoélectrique sur le substrat support, de sorte à former un substrat pour dispositif radiofréquence selon l'invention ;
- la figure 5 est une vue en coupe du substrat pour dispositif radiofréquence après amincissement du substrat piézoélectrique ;
- la figure 6 est une illustration schématique d'un filtre à onde acoustique de surface selon un mode de réalisation de l'invention.

Pour des raisons de lisibilité des figures, les éléments illustrés ne sont pas nécessairement représentés à l'échelle. Par ailleurs, les éléments désignés par les mêmes signes de référence sur différentes figures sont identiques ou remplissent la même fonction.

**DESCRIPTION DETAILLEE DE MODES DE REALISATION DE L'INVENTION**

Un premier objet de l'invention concerne un procédé de fabrication d'un substrat pour dispositif radiofréquence, dit substrat final, par assemblage via collage d'une couche piézoélectrique sur un substrat support.

Le substrat support 1 est fabriqué dans un matériau possédant un coefficient de dilatation thermique inférieur à celui du matériau constitutif du substrat piézoélectrique 3. Ainsi, le substrat support joue le rôle d'un raidisseur qui limite la dilatation du substrat piézoélectrique lors de variations de température auxquelles il est soumis, ce qui permet de diminuer le coefficient thermique de fréquence du substrat piézoélectrique, c'est-à-dire la mesure dans laquelle la fréquence d'une onde se propageant dans le substrat piézoélectrique varie en fonction de la température. Des matériaux adaptés sont par exemple le silicium, le saphir, le nitrure d'aluminium (AlN) polycristallin, ou encore l'arséniure de gallium (GaAs). Le silicium est particulièrement préféré car il permet la mise en oeuvre du procédé dans des lignes de production de microélectronique qui sont adaptées au silicium.

Dans la présente invention, on s'intéresse au coefficient de dilatation thermique dans un plan parallèle à la surface principale des substrats.

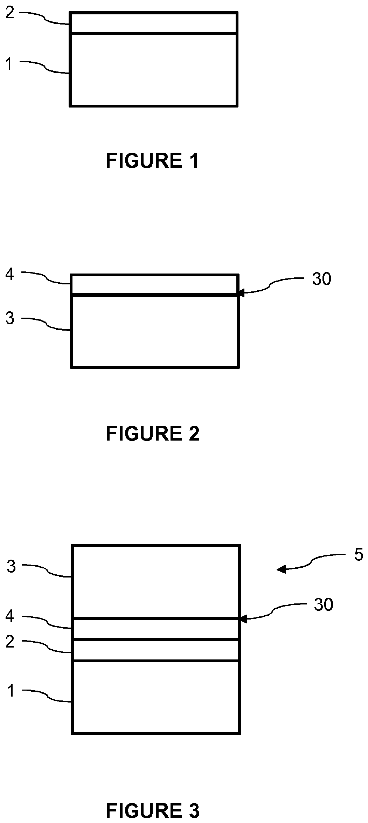

Selon une première étape représentée sur la figure 1, une couche adhésive photo-polymérisable 2 est déposée sur une face exposée du substrat support 1.

Le dépôt de la couche adhésive photo-polymérisable est avantageusement effectué par enduction centrifuge, ou « spin coating » en terminologie anglo-saxonne. Cette technique consiste à faire tourner le substrat sur lequel est prévu le dépôt de la couche photo-polymérisable sur lui-même à une vitesse sensiblement constante et relativement élevée, afin d'étaler ladite couche photo-polymérisable de façon uniforme sur l'ensemble de la surface du substrat par force centrifuge. A cet effet, le substrat est typiquement posé et maintenu par tirage du vide sur un plateau tournant.

L'homme du métier est en mesure de déterminer les conditions opératoires, telles que le volume d'adhésif déposé sur la surface du substrat, la vitesse de rotation du substrat, et la durée minimale du dépôt en fonction de l'épaisseur souhaitée pour la couche adhésive.

L'épaisseur de la couche adhésive photo-polymérisable 2 est typiquement comprise entre 2 $\mu$m (micromètres) et 8 $\mu$m.

Selon un exemple non limitatif, la couche adhésive photo-polymérisable commercialisée sous la référence « NOA 61 » par la société NORLAND PRODUCTS peut être utilisée dans la présente invention.

Selon une deuxième étape, on forme une couche diélectrique 4 sur une face principale rugueuse 30 du substrat piézoélectrique 3. La figure 2 représente le substrat piézoélectrique 3 sur lequel a été déposée une couche diélectrique 4. On comprendra que cette deuxième étape peut être réalisée préalablement, parallèlement, ou ultérieurement à la première étape de dépôt de la couche adhésive photo-polymérisable.

Selon un mode de réalisation, la couche diélectrique 4 est une couche d'oxyde de silicium, ou une couche de nitrure de silicium, ou une couche comprenant une combinaison de nitrure et d'oxyde de silicium, ou une superposition d'au moins une couche d'oxyde et d'une couche de nitrure de silicium. Par exemple, on pourra former une couche d'oxyde de silicium $SiO_2$, ou une couche de nitrure $Si_3N_4$, une couche comprenant une combinaison de nitrure et d'oxyde SiOxNy, ou une superposition d'une couche d'oxyde $SiO_2$ et d'une couche de nitrure $Si_3N_4$. Ces matériaux sont en effet classiquement utilisés dans des dispositifs radiofréquence pour guider les ondes acoustiques de surface, notamment sous la forme d'un empilement $SiO_2$ / $Si_3N_4$. La ou les couches d'oxyde et/ou de nitrure de silicium sont de préférence déposées par dépôt chimique en phase vapeur assisté par plasma (PECVD).

Selon un mode de réalisation préféré, la couche diélectrique 4 est une couche de verre déposée par centrifugation sur le substrat piézoélectrique, dite « spin-on glass » (SOG) selon la terminologie anglo-saxonne. Cette technique est avantageuse en ce que le dépôt de la couche est effectué à température ambiante, et est suivi d'un recuit de densification à une température d'environ 250°C, et n'engendre donc pas de déformation du substrat sur lequel la couche diélectrique est formée.

Une couche diélectrique d'oxyde ou de type SOG permet de maintenir les performances acoustiques d'un dispositif radiofréquence obtenu ultérieurement à partir du substrat piézoélectrique à un niveau optimal.

On choisira de préférence une telle couche diélectrique d'oxyde ou de type SOG possédant un effet lissant, c'est-à-dire que sa surface libre ne se conforme pas à la surface rugueuse du substrat piézoélectrique mais est sensiblement lisse ou tout au moins présente une rugosité bien inférieure à celle du substrat piézoélectrique. Ainsi, la surface libre de la couche diélectrique est suffisamment lisse pour permettre un collage de bonne qualité sur le substrat support.

Le substrat piézoélectrique 3 est ensuite collé sur le substrat support 1 par l'intermédiaire de la couche diélectrique 4 et de la couche adhésive 2, afin de former un substrat assemblé 5, dont un mode de réalisation est représenté sur la figure 3.

Le substrat assemblé 5 est ainsi formé de la superposition du substrat support 1, de la couche adhésive 2, de la couche diélectrique 4, et du substrat piézoélectrique 3, la couche adhésive 2 et la couche diélectrique 4 se trouvant à l'interface entre le substrat support 1 et le substrat piézoélectrique 3. La surface rugueuse 30 de la couche piézoélectrique 3 se trouve ainsi à l'interface de ladite couche piézoélectrique 3 et de la couche diélectrique 4, et est adaptée pour réfléchir une onde radiofréquence qui se déplace dans la couche piézoélectrique.

Le collage est de préférence réalisé à température ambiante, soit environ 20°C. Il est cependant possible de réaliser le collage à chaud à une température comprise entre 20°C et 50°C, et de manière davantage préférée entre 20°C et 30°C.

De plus, l'étape de collage est avantageusement effectuée à basse pression, c'est-à-dire à une pression inférieure ou égale à 5mTorr, ce qui permet de désorber l'eau des surfaces formant l'interface de collage, c'est-à-dire la surface de la couche adhésive et la surface rugueuse du substrat piézoélectrique. Réaliser l'étape de collage sous vide permet d'améliorer encore davantage la désorption de l'eau à l'interface de collage.

L'utilisation de la couche polymère 2 en tant que couche de collage permet d'une part de coller le substrat piézoélectrique 3 avec le substrat support 1 de manière efficace, en particulier parce que la surface 30 du substrat piézoélectrique est rugueuse, et il est communément admis qu'un matériau polymère se colle plus facilement sur une surface légèrement rugueuse. D'autre part, le dépôt de la couche adhésive 2, l'assemblage des substrats 1 et 3, et l'irradiation du substrat assemblé 5 s'effectuent plus rapidement et de manière simplifiée par rapport aux techniques de l'état de l'art pour lesquelles les dépôts successifs de couches de $SiO_2$ sur la surface rugueuse et sur la surface opposée à la surface rugueuse de la couche piézoélectrique sont longs et fastidieux à mettre en oeuvre.

De plus, le procédé proposé présente un coût fortement réduit, puisque le dépôt et l'irradiation UV de la couche adhésive sont bien moins coûteux que les dépôts de $SiO_2$ successifs, et ne nécessitent pas la réalisation des polissages mécano-chimiques (CMP).

Le collage par couche polymère proposé permet également de régler un autre problème majeur survenant lors des dépôts successifs de couches de $SiO_2$, à savoir la création d'une courbure importante non désirée dans le substrat, qui gêne la fabrication de dispositifs radiofréquence à partir dudit substrat, en s'affranchissant de tels dépôts de $SiO_2$. Le procédé de l'invention permet ainsi d'éviter, ou tout du moins de réduire, les déformations du substrat piézoélectrique et du substrat support lors du dépôt de la couche diélectrique et de la couche adhésive respectivement, de même que le substrat final obtenu après collage et irradiation.

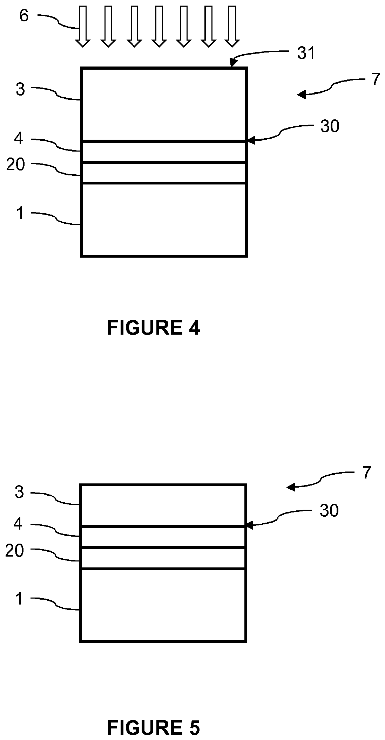

On soumet ensuite le substrat assemblé 5 à une irradiation par un flux lumineux 6, afin de polymériser la couche adhésive 2. L'irradiation du substrat assemblé 5 est représentée sur la figure 4.

La source lumineuse est de préférence un laser.

Le rayonnement lumineux 5, ou flux lumineux, est de préférence un rayonnement ultra-violet (UV). En fonction de la composition de la couche adhésive 2, on choisira de préférence un rayonnement UV présentant une longueur d'onde comprise entre 320 nm (nanomètres) et 365 nm.

L'irradiation est effectuée en exposant la face libre 31 du substrat piézoélectrique au rayonnement lumineux incident 6. Ainsi, le rayonnement lumineux pénètre dans le substrat assemblé 5 depuis la face libre 31 du substrat piézoélectrique 3, traverse le substrat piézoélectrique, traverse la couche diélectrique 4, jusqu'à atteindre la couche adhésive 2, provoquant ainsi la polymérisation de ladite couche adhésive.

La polymérisation de la couche adhésive permet de former une couche polymère 20 qui assure la cohésion mécanique du substrat assemblé, en maintenant collés ensemble le substrat support 1 et le substrat piézoélectrique 3 qui forment le substrat final 7.

L'irradiation du substrat assemblé 5 donne lieu à un processus thermique selon lequel la couche piézoélectrique 3, traversée par le rayonnement, peut absorber en partie l'énergie du rayonnement et s'échauffer. Un échauffement trop important serait susceptible de déstabiliser la structure de la couche piézoélectrique, ce qui pourrait aboutir à une dégradation des propriétés physiques et chimiques de la couche piézoélectrique. En outre, un échauffement trop important occasionnerait une déformation de la couche piézoélectrique et du substrat support en raison de leur différence de coefficient de dilatation thermique, aboutissant à une déformation globale (« bow »), du substrat assemblé et donc du substrat final résultant.

Afin d'éviter un échauffement trop important de la couche piézoélectrique 3, l'irradiation est avantageusement effectuée de manière impulsionnelle, c'est-à-dire en exposant le substrat assemblé à une pluralité d'impulsions de rayons lumineux. Chaque impulsion est réalisée pendant un temps d'irradiation déterminé, qui peut être égal ou différent d'une impulsion à l'autre. Les impulsions sont espacées dans le temps par un temps de repos déterminé pendant lequel le substrat assemblé n'est pas exposé aux rayons lumineux.

L'homme du métier est en mesure de déterminer le temps d'irradiation de chaque impulsion, le temps de repos entre chaque impulsion, ainsi que le nombre d'impulsions à réaliser pour polymériser complètement la couche adhésive.

Ainsi, par exemple, on pourra mettre en oeuvre une dizaine d'impulsions durant 10 secondes chacune, séparées par des temps de repos durant également 10 secondes chacun.

Après irradiation, on obtient un substrat final constitué du substrat assemblé avec une couche adhésive polymérisée.

L'épaisseur de la couche adhésive polymérisée 20 est de préférence comprise entre 2 μm (micromètres) et 8 μm. Cette épaisseur dépend notamment du matériau constitutif de la couche adhésive photo-polymérisable déposée avant collage, de l'épaisseur de ladite couche adhésive photo-polymérisable, et des conditions expérimentales d'irradiation.

De manière optionnelle, on procède, après polymérisation de la couche adhésive, à un amincissement du substrat piézoélectrique 3, en retirant de la matière depuis la face exposée 31. Cette étape d'amincissement permet de réduire l'épaisseur de la couche piézoélectrique et d'obtenir ainsi, sur le substrat support 1, une couche piézoélectrique 3 d'une épaisseur déterminée. Le substrat final 7 présentant une couche piézoélectrique amincie 3 est représenté sur la figure 5. L'étape d'amincissement peut notamment être réalisée par gravure et/ou par polissage mécano-chimique de la couche piézoélectrique.

Après amincissement, on réalise préférablement un recuit de lissage de la couche piézoélectrique amincie. Le lissage consiste en un traitement de surface visant à rendre la surface exposée de la couche piézoélectrique plane et à en réduire la rugosité.

Les étapes du procédé qui sont postérieures au collage du substrat piézoélectrique 3 sur le substrat support 1 sont réalisées à une température inférieure ou égale à 300°C, afin de ne pas dégrader leur structure, en particulier la structure de la couche adhésive 2, 20 ni engendrer de déformation des substrats.

Un deuxième objet de l'invention concerne un procédé de fabrication d'un dispositif radiofréquence, tel qu'un résonateur ou un filtre, à partir d'un substrat final obtenu par la mise en oeuvre du procédé de fabrication décrit précédemment selon le premier objet de l'invention, ainsi qu'un tel dispositif radiofréquence. La fabrication d'un tel dispositif radiofréquence est en effet possible à une température ne dépassant pas 300°C.

Parmi les dispositifs radiofréquence réalisables, le procédé décrit se prête tout particulièrement à la fabrication d'un filtre à onde acoustique de surface. Dans ce dernier cas, il s'agit d'abord de fabriquer le substrat final selon le procédé précédent, puis de former une paire d'électrodes interdigitées sur la surface de la couche piézoélectrique du substrat final.

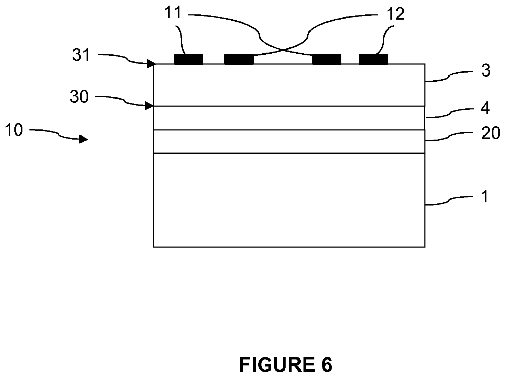

La figure 6 est une vue de principe d'un filtre à ondes acoustiques de surface 10 selon un mode de réalisation, fabriqué à partir d'un substrat final 7 tel que décrit précédemment. Le filtre comprend une couche piézoélectrique 3 et deux électrodes 11, 12 sous la forme de deux peignes métalliques interdigités déposés sur la surface 31 de ladite couche piézoélectrique. Du côté opposé aux électrodes, la couche piézoélectrique 3 repose par le biais de sa surface rugueuse 30 sur une couche diélectrique 4, une couche adhésive polymérisée 20, et un substrat support 1. La couche piézoélectrique 3 est monocristalline, une excellente qualité cristalline étant en effet nécessaire pour ne pas engendrer d'atténuation de l'onde de surface.

Par rapport à un collage utilisant une couche adhésive polymérisée sur la couche piézoélectrique et le substrat support les performances d'un tel filtre à ondes acoustiques de surface se voient améliorées car la couche diélectrique sur la couche piézoélectrique présente une interface rugueuse et de contraste en impédance acoustique. Une couche adhésive polymérisée en contact avec la couche piézoélectrique aurait des influences néfastes non négligeables sur les performances.

**Revendications**

1. Procédé de fabrication d'un substrat (7) pour dispositif radiofréquence par assemblage d'une couche piézoélectrique (3) sur un substrat support (1) par l'intermédiaire d'une couche électriquement isolante, la couche piézoélectrique (3) présentant une surface rugueuse (30) présentant une rugosité comprise entre 0,3 et 5 $\mu$m RMS à son interface avec la couche électriquement isolante, ladite rugosité étant choisie du même ordre de grandeur que la longueur d'onde d'une onde radiofréquence destinée à se propager dans la couche piézoélectrique, de sorte à réfléchir une onde parasite sur ladite surface rugueuse, ledit procédé étant **caractérisé en ce qu'**il comprend les étapes suivantes :

   - la fourniture d'un substrat piézoélectrique (3) présentant ladite surface rugueuse (30),
   - le dépôt d'une couche diélectrique (4) sur la surface rugueuse (30) du substrat piézoélectrique (3), ladite couche diélectrique comprenant une couche d'oxyde de silicium, une couche de nitrure de silicium, une couche comprenant une combinaison de nitrure et d'oxyde de silicium, et/ou une superposition d'au moins une couche d'oxyde et d'une couche de nitrure de silicium déposée sur le substrat piézoélectrique (3) par dépôt chimique en phase vapeur assisté par plasma, ou une couche de verre déposée par centrifugation sur le substrat piézoélectrique (3),
   - la fourniture d'un substrat support (1),
   - le dépôt d'une couche adhésive photo-polymérisable (2) sur le substrat support,
   - le collage du substrat piézoélectrique (3) sur le substrat support (1) par l'intermédiaire de la couche diélectrique (4) et de la couche adhésive (2), pour former un substrat assemblé (5),
   - l'irradiation du substrat assemblé (5) par un flux lumineux (6) pour polymériser la couche adhésive (2), ladite couche adhésive (2) et la couche diélectrique (4) formant ensemble la couche électriquement isolante.

2. Procédé selon la revendication 1, dans lequel l'épaisseur de la couche adhésive photo-polymérisable (2) est comprise entre 2 $\mu$m et 8 $\mu$m.

3. Procédé selon l'une quelconque des revendications précédentes, dans lequel le dépôt de la couche adhésive photo-polymérisable (2) est mis en oeuvre par enduction centrifuge.

4. Procédé selon l'une quelconque des revendications précédentes, dans lequel l'étape de collage est mise en oeuvre à une température comprise entre 20 et 50°C, de préférence entre 20°C et 30°C.

5. Procédé selon l'une quelconque des revendications précédentes, dans lequel le flux lumineux (6) est appliqué au travers du substrat piézoélectrique (3).

6. Procédé selon l'une quelconque des revendications précédentes, dans lequel l'irradiation est mise en oeuvre de manière impulsionnelle.

7. Procédé selon l'une quelconque des revendications précédentes, dans lequel le flux lumineux (6) présente une longueur d'onde comprise entre 320 nm et 365 nm.

8. Procédé selon l'une quelconque des revendications précédentes, dans lequel le substrat support (1) est en un matériau possédant un coefficient de dilatation thermique inférieur à celui du matériau constitutif du substrat piézoélectrique (3).

9. Procédé selon l'une quelconque des revendications précédentes, dans lequel le substrat support (1) est en silicium, en saphir, en nitrure d'aluminium (AlN) polycristallin, ou en arséniure de gallium (GaAs).

10. Procédé selon l'une quelconque des revendications précédentes, comprenant en outre, après la polymérisation de la couche adhésive (2), une étape d'amincissement du substrat piézoélectrique (3) de sorte à transférer sur le substrat support (1) une couche piézoélectrique (3) d'une épaisseur déterminée.

11. Procédé selon la revendication 10, dans lequel ladite étape d'amincissement comprend une gravure et/ou un polissage mécano-chimique.

12. Procédé selon l'une des revendications 10 ou 11, comprenant, après l'étape d'amincissement, la mise en oeuvre d'un recuit de lissage de la couche piézoélectrique.

**13.** Procédé selon l'une quelconque des revendications précédentes, dans lequel chaque étape postérieure au collage est mise en oeuvre à une température inférieure ou égale à 300°C.

**14.** Procédé de fabrication d'un filtre radiofréquence (10), comprenant :

- la fabrication d'un substrat (7) par le procédé selon l'une quelconque des revendications précédentes,
- la formation d'une paire d'électrodes interdigitées (11, 12) sur la surface (31) de la couche piézoélectrique dudit substrat.

**15.** Substrat (7) pour dispositif radiofréquence susceptible d'être obtenu par le procédé selon l'une des revendications 1 à 13, comprenant successivement un substrat support (1), une couche électriquement isolante (2, 4) et une couche piézoélectrique (3) présentant, à son interface avec la couche électriquement isolante, une surface rugueuse (30) présentant une rugosité comprise entre 0,3 et 5 μm RMS adaptée pour réfléchir une onde radiofréquence, la couche électriquement isolante comprenant successivement, du substrat support (1) vers la couche piézoélectrique (3), une couche adhésive polymérisée (2) et une couche diélectrique (4), ladite couche diélectrique comprenant une couche d'oxyde de silicium, une couche de nitrure de silicium, une couche comprenant une combinaison de nitrure et d'oxyde de silicium, et/ou une superposition d'au moins une couche d'oxyde et d'une couche de nitrure de silicium, ou une couche de verre.

**16.** Filtre radiofréquence (10), comprenant un substrat selon la revendication 15 et une paire d'électrodes interdigitées (11, 12) s'étendant sur la surface (31) de la couche piézoélectrique (3).

**Patentansprüche**

**1.** Verfahren zur Herstellung eines Substrats (7) für eine Hochfrequenzvorrichtung durch Verbinden einer piezoelektrischen Schicht (3) auf einem Trägersubstrat (1) mittels einer elektrisch isolierenden Schicht, wobei die piezoelektrische Schicht (3) eine raue Oberfläche (30) mit einer Rauheit zwischen 0,3 und 5 μm RMS an ihrer Schnittstelle mit der elektrisch isolierenden Schicht aufweist, wobei die Rauheit in derselben Größenordnung wie die Wellenlänge einer Hochfrequenzwelle gewählt ist, die sich in der piezoelektrischen Schicht ausbreiten soll, so dass eine Störwelle auf der rauen Oberfläche reflektiert wird, wobei das Verfahren **dadurch gekennzeichnet ist, dass** es die folgenden Schritte umfasst:

- Bereitstellen eines piezoelektrischen Substrats (3) mit der rauen Oberfläche (30),
- Ablagern einer dielektrischen Schicht (4) auf der rauen Oberfläche (30) des piezoelektrischen Substrats (3), wobei die dielektrische Schicht eine Siliziumoxidschicht, eine Siliziumnitridschicht, eine Schicht, die eine Kombination aus Nitrid und Siliziumoxid umfasst, und/oder eine Überlagerung aus wenigstens einer Oxidschicht und einer Siliziumnitridschicht, abgelagert auf dem piezoelektrischen Substrat (3) durch plasmaunterstützte chemische Dampfphasenablagerung, oder eine durch Zentrifugation auf dem piezoelektrischen Substrat (3) abgelagerte Glasschicht umfasst,
- Bereitstellen eines Trägersubstrats (1),
- Ablagern einer photopolymerisierbaren Klebeschicht (2) auf dem Trägersubstrat,
- Verkleben des piezoelektrischen Substrats (3) auf dem Trägersubstrat (1) mittels der dielektrischen Schicht (4) und der Klebeschicht (2), um ein verbundenes Substrat (5) zu bilden,
- Bestrahlen des verbundenen Substrats (5) mit einem Lichtstrom (6) zur Polymerisation der Klebeschicht (2), wobei die Klebeschicht (2) und die dielektrische Schicht (4) zusammen die elektrisch isolierende Schicht bilden.

**2.** Verfahren nach Anspruch 1, wobei die Dicke der photopolymerisierbaren Klebeschicht (2) zwischen 2 μm und 8 μm liegt.

**3.** Verfahren nach einem der vorhergehenden Ansprüche, wobei die Ablagerung der photopolymerisierbaren Klebeschicht (2) durch Zentrifugalbeschichtung erfolgt.

**4.** Verfahren nach einem der vorhergehenden Ansprüche, wobei der Klebeschritt bei einer Temperatur zwischen 20 und 50 °C, vorzugsweise zwischen 20 °C und 30 °C, durchgeführt wird.

**5.** Verfahren nach einem der vorhergehenden Ansprüche, wobei der Lichtstrom (6) durch das piezoelektrische Substrat (3) angewendet wird.

**6.** Verfahren nach einem der vorhergehenden Ansprüche, wobei die Bestrahlung impulsartig durchgeführt wird.

**7.** Verfahren nach einem der vorhergehenden Ansprüche, wobei der Lichtstrom (6) eine Wellenlänge zwischen 320 nm und 365 nm aufweist.

**8.** Verfahren nach einem der vorhergehenden Ansprüche, wobei das Trägersubstrat (1) aus einem Material besteht, das einen geringeren Wärmeausdehnungskoeffizienten aufweist als das Material, aus dem das piezoelektrische Substrat (3) besteht.

9. Verfahren nach einem der vorhergehenden Ansprüche, wobei das Trägersubstrat (1) aus Silizium, Saphir, polykristallinem Aluminiumnitrid (AlN) oder Galliumarsenid (GaAs) ist.

10. Verfahren nach einem der vorhergehenden Ansprüche, ferner umfassend, nach der Polymerisation der Klebeschicht (2), einen Schritt der Verschlankung des piezoelektrischen Substrats (3) derart, dass eine piezoelektrische Schicht (3) einer bestimmten Dicke auf das Trägersubstrat (1) übertragen wird.

11. Verfahren nach Anspruch 10, wobei der Verschlankungsschritt ein Ätzen und/oder ein mechanisch-chemisches Polieren umfasst.

12. Verfahren nach einem der Ansprüche 10 oder 11, das nach dem Verschlankungsschritt die Durchführung eines Glättungsglühens der piezoelektrischen Schicht umfasst.

13. Verfahren nach einem der vorhergehenden Ansprüche, wobei jeder Schritt nach dem Kleben bei einer Temperatur von 300 °C oder weniger durchgeführt wird.

14. Verfahren zur Herstellung eines Hochfrequenzfilters (10), umfassend:

   - das Herstellen eines Substrats (7) durch das Verfahren nach einem der vorhergehenden Ansprüche,
   - das Bilden eines Paares interdigitierter Elektroden (11, 12) auf der Oberfläche (31) der piezoelektrischen Schicht des Substrats.

15. Substrat (7) für Hochfrequenzvorrichtung, das durch das Verfahren nach einem der Ansprüche 1 bis 13 erhalten werden kann, nacheinander umfassend ein Trägersubstrat (1), eine elektrisch isolierende Schicht (2, 4) und eine piezoelektrische Schicht (3), die an ihrer Schnittstelle mit der elektrisch isolierenden Schicht eine raue Oberfläche (30) aufweist, die eine Rauheit zwischen 0,3 und 5 $\mu$m RMS aufweist, die geeignet ist, eine Hochfrequenzwelle zu reflektieren, wobei die elektrisch isolierende Schicht nacheinander vom Trägersubstrat (1) zur piezoelektrischen Schicht (3) eine polymerisierte Klebeschicht (2) und eine dielektrische Schicht (4) umfasst, wobei die dielektrische Schicht eine Siliziumoxidschicht, eine Siliziumnitridschicht, eine Schicht, die eine Kombination aus Nitrid und Siliziumoxid umfasst, und/oder eine Überlagerung aus wenigstens einer Oxidschicht und einer Siliziumnitridschicht oder eine Glasschicht umfasst.

16. Hochfrequenzfilter (10), umfassend ein Substrat nach Anspruch 15 und ein Paar interdigitierter Elektroden (11, 12), die sich auf der Oberfläche (31) der piezoelektrischen Schicht (3) erstrecken.

**Claims**

1. Method of manufacturing a substrate (7) for a radio-frequency device by assembling a piezoelectric layer (3) on a support substrate (1) via an electrically insulating layer, the piezoelectric layer (3) having a roughened surface (30) with a roughness of between 0,3 and 5 $\mu$m RMS at its interface with the electrically insulating layer, said roughness being chosen to be of the same order of magnitude as the wavelength of a radio-frequency wave intended to propagate in the piezoelectric layer, so as to reflect a parasitic wave onto said rough surface, said method being **characterized in that** it comprises the following steps:

   - providing a piezoelectric substrate (3) with said roughened surface (30),
   - depositing a dielectric layer (4) on the roughened surface (30) of the piezoelectric substrate (3), said dielectric layer comprising a silicon oxide layer, a silicon nitride layer, a layer comprising a combination of nitride and silicon oxide, and/or a superposition of at least one oxide layer and a silicon nitride layer deposited on the piezoelectric substrate (3) by plasma-assisted chemical vapor deposition, or a glass layer spin-coated on the piezoelectric substrate (3),
   - providing a support substrate (1),
   - depositing a photopolymerizable adhesive layer (2) on the support substrate,
   - bonding the piezoelectric substrate (3) to the support substrate (1) via the dielectric layer (4) and the adhesive layer (2), to form an assembled substrate (5),
   - irradiating the assembled substrate (5) with a light flux (6) to polymerize the adhesive layer (2), said adhesive layer (2) and dielectric layer (4) together forming the electrically insulating layer.

2. Method according to claim 1, wherein the thickness of the photo-polymerizable adhesive layer (2) is between 2 $\mu$m and 8 $\mu$m.

3. Method according to any of the preceding claims, wherein the photo-polymerizable adhesive layer (2) is deposited by centrifugal coating.

4. Method according to any one of the preceding claims, wherein the bonding step is carried out at a temperature of between 20 and 50°C, preferably between 20°C and 30°C.

5. Method according to any of the preceding claims, wherein the light flux (6) is applied through the piezoelectric substrate (3).

6. Method according to any of the preceding claims, wherein the irradiation is carried out in a pulsed manner.

7. Method according to any of the preceding claims, wherein the light flux (6) has a wavelength between 320 nm and 365 nm.

8. Method according to any of the preceding claims, wherein the support substrate (1) is made of a material with a lower coefficient of thermal expansion than the material making up the piezoelectric substrate (3).

9. Method according to any of the preceding claims, wherein the support substrate (1) is made of silicon, sapphire, polycrystalline aluminum nitride (AlN) or gallium arsenide (GaAs).

10. Method according to any one of the preceding claims, further comprising, after polymerization of the adhesive layer (2), a step of thinning the piezoelectric substrate (3) so as to transfer onto the support substrate (1) a piezoelectric layer (3) of determined thickness.

11. Method according to claim 10, wherein said thinning step comprises etching and/or chemical-mechanical polishing.

12. Method according to one of claims 10 or 11, comprising, after the thinning step, carrying out a smoothing annealing of the piezoelectric layer.

13. Method according to any of the preceding claims, wherein each post-bonding step is carried out at a temperature less than or equal to 300°C.

14. Method of manufacturing a radio-frequency filter (10), comprising:

- manufacturing a substrate (7) by the method according to any of the preceding claims,
- forming a pair of interdigitated electrodes (11, 12) on the surface (31) of the piezoelectric layer of said substrate.

15. Substrate (7) for a radiofrequency device obtainable by the method according to one of claims 1 to 13, successively comprising a support substrate (1), an electrically insulating layer (2, 4) and a piezoelectric layer (3) having, at its interface with the electrically insulating layer, a roughened surface (30) having a roughness of between 0.3 and 5 μm RMS adapted to reflect a radiofrequency wave, the electrically insulating layer comprising successively, from the supporting substrate (1) to the piezoelectric layer (3), a polymerized adhesive layer (2) and a dielectric layer (4), said dielectric layer comprising a silicon oxide layer, a silicon nitride layer, a layer comprising a combination of silicon nitride and oxide, and/or a superposition of at least one oxide layer and a silicon nitride layer, or a glass layer.

16. Radio-frequency filter (10), comprising a substrate according to claim 15 and a pair of interdigitated electrodes (11, 12) extending over the surface (31) of the piezoelectric layer (3).

2

1

**FIGURE 1**

4

3

30

**FIGURE 2**

3

5

4

30

2

1

**FIGURE 3**

**FIGURE 4**

**FIGURE 5**

**FIGURE 6**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3053532
- FR 3045678
- US 2012086312 A
- US 20060076584 A